# EUROPEAN PATENT SPECIFICATION

(11) **EP 4 482 264 B1**
(45) Date of publication and mention of the grant of the patent: **07.05.2025**
(21) Application number: 24180796.5
(22) Date of filing: 07.06.2024
(51) Int. Cl.: H05K 1/18, H05K 1/02

(54) **ILLUMINATION DEVICE**
BELEUCHTUNGSVORRICHTUNG
DISPOSITIF D'ÉCLAIRAGE

(30) Priority: 19.06.2023 JP 2023100008
(43) Date of publication of application: 25.12.2024
(73) Proprietor: Yazaki Corporation, Minato-ku Tokyo, 108-0075 (JP)
(72) Inventor: Osanai, Tomoki, Makinohara-shi, Shizuoka, 421-0407 (JP); Nagaushi, Naoki, Makinohara-shi, Shizuoka, 421-0407 (JP)
(74) Representative: Grünecker Patent- und Rechtsanwälte PartG mbB

(56) References cited:
- US-A1- 2011 175 548
- US-A1- 2012 181 560
- US-B2- 10 665 576
- US-B2- 8 198 109

## Description

### BACKGROUND OF THE INVENTION

### Technical Field

The present invention relates to an illumination device.

### Background Art

Patent Document 1 discloses an illumination device which includes two light emitters used for different purposes, i.e., a first light emitter 13A and a second light emitter 13B, wherein the first light emitter 13A is used as illumination for a charging inlet and the second light emitter 13B is used as an indicator. The illumination device as disclosed in Patent Document 1 is configured such that the first light emitter 13A and the second light emitter 13B are provided on a front side and on a back side of a board 7, respectively.

### Citation List

### Patent Literature

Patent Document 1: JP 2023-42051 A
Further prior art is known from document US 10 665 576 B2 which discloses an illumination device comprising a board having a first face and a second face opposite to the first face. It comprises a first light source disposed on the first face and a second light source disposed on the second face. Additionally a second wiring pattern is disposed on the second face and the second wiring pattern is disposed so as to cover a region on the second face and the region on the second face is opposite to a region on the first face with the first light source disposed therein.
From document US 8 198 109 B2 it is known a solid state light sheet and method of fabricating the sheet. In one embodiment, bare LED chips have top and bottom electrodes, where the bottom electrode is a large reflective electrode. The bottom electrodes of an array of LEDs (e.g., 500 LEDs) are bonded to an array of electrodes formed on a flexible bottom substrate. Conductive traces are formed on the bottom substrate connected to the electrodes. In an embodiment LED dies are oppositely mounted in a light sheet. The dies are connected in series by alternating the orientation of the LED dies along the light sheet to connect the anode of one LED die to the cathode of an adjacent LED die using metal conductors.

### SUMMARY OF THE INVENTION

Generally, a board is made of an insulator such as a resin and/or glass and transparent for light. In the case where light sources are arranged on two opposite faces of the board, as is in the illumination device according to Patent Document 1, a light coming from a light source on the front side may e.g. pass through the board to reach the back side of the board. As a result, a user may misrecognize that a light source on the back side of the board were tumed on, despite the light source on the back side not being turned on. For example, in the case where the light source on the back side of the board is used as the indicator, as is in the illumination device according to Patent Document 1, the above-described situation may cause a user to misrecognize that the indicator were turned on, despite the light source on the back side emitting no light.

Therefore, an object of the present invention is to provide an illumination device which includes two light sources to be used for different purposes.

In order to achieve the above-mentioned objective, an embodiment of the present invention relates to an illumination device including the features of claim 1.

The present invention enables an illumination device to be provided which includes two light sources to be used for different purposes.

### BRIEF DESCRIPTION OF THE DRAWINGS

Fig. 1 shows an illumination device 100 according to an embodiment of the present invention;
Fig. 2 shows a view of a board 110 from its first face 111 side;
Fig. 3 shows a view of the board 110 from its second face 112 side;
Fig. 4 shows a sectional view of the board 110 according to Figs. 2 and 3 along the line AA; and
Fig. 5 shows a sectional view of the board 110 according to Figs. 2 and 3 along the line BB.

### DETAILED DESCRIPTION OF THE PREFERRED EMBODIMENTS

### <Illumination device 100>

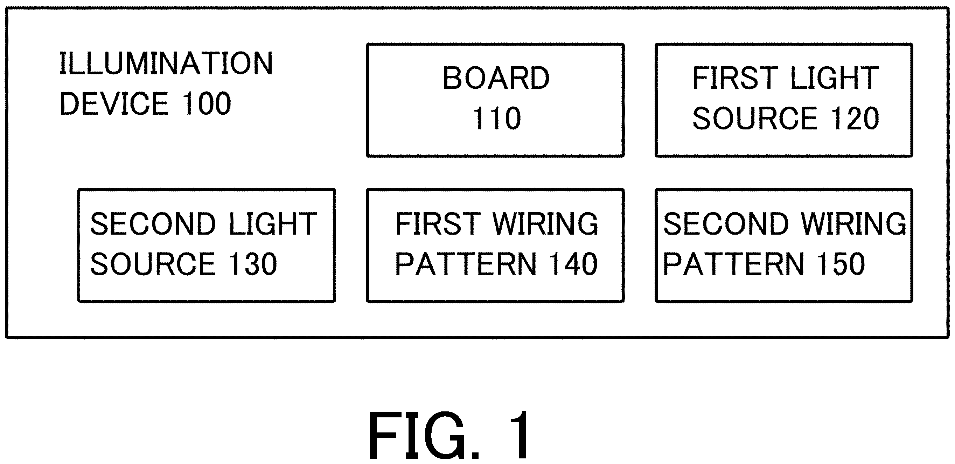

Fig. 1 shows an illumination device 100 according to an embodiment of the present invention. The illumination device 100 includes a board 110, a first light source 120, a second light source 130, first wiring patterns 140, and second wiring patterns 150. For example, the illumination device 100 is configured for illuminating a charging inlet of a vehicle.

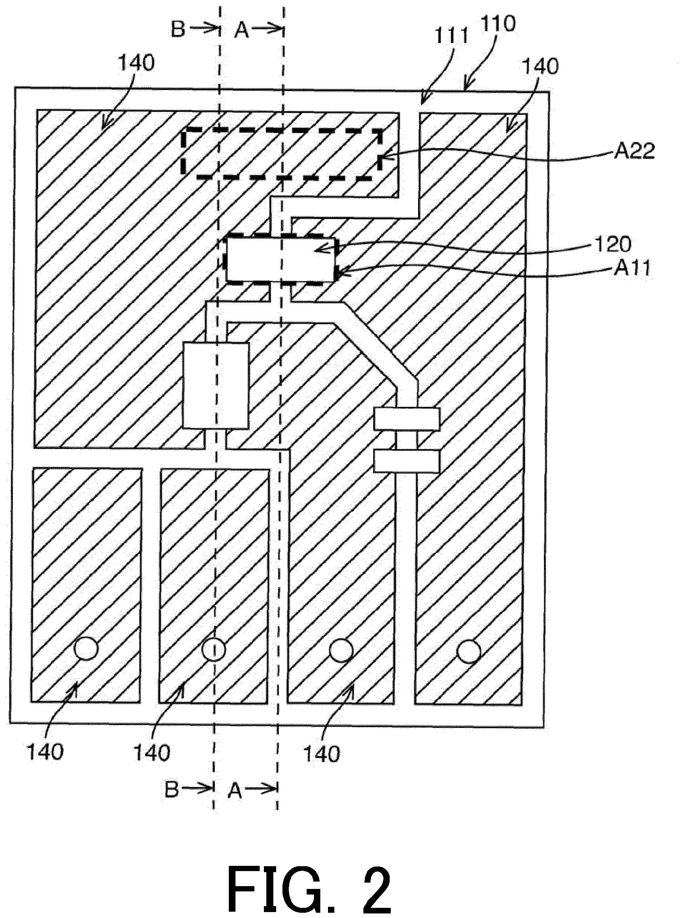

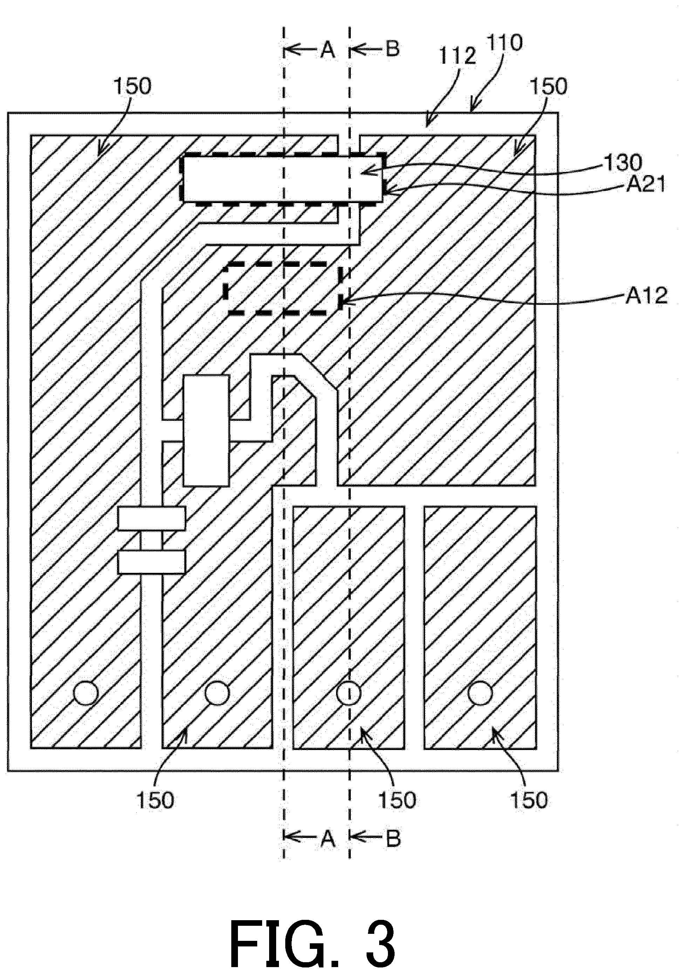

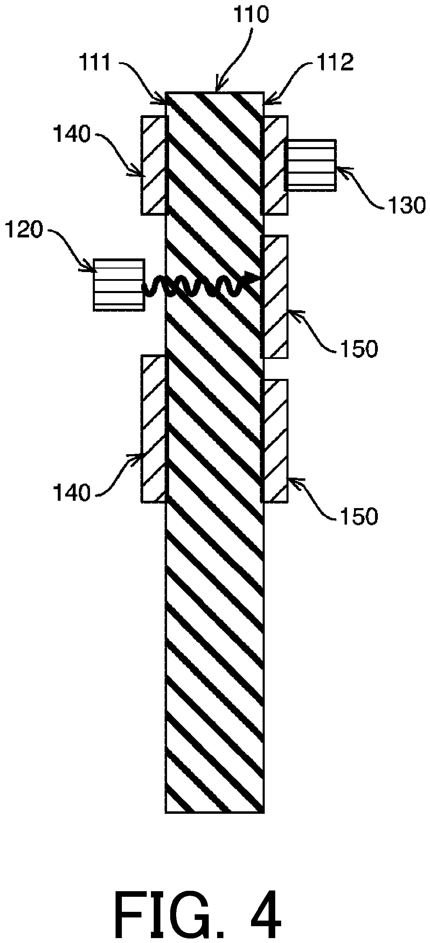

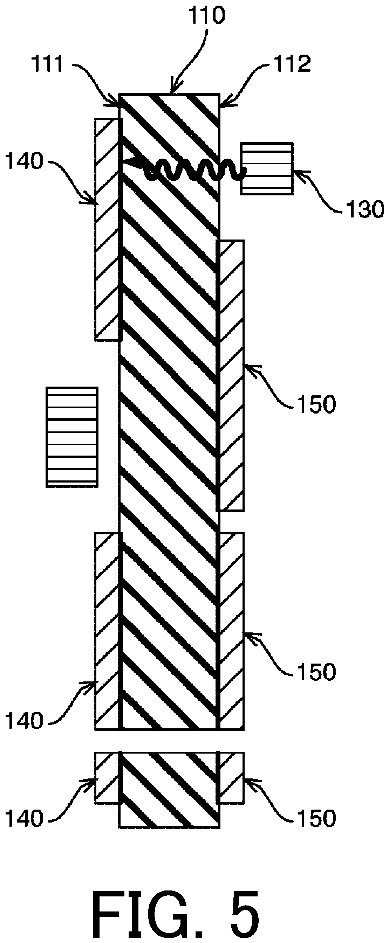

The board 110 is an element having a plate shape and has a first face 111 and a second face 112 opposite to the first face 111. The board 110 is made of an insulator (for example a resin and/or a glass) and transparent for light. Fig. 2 shows a view of the board 110 from its first face 111 side, Fig. 3 shows a view of the board 110 from its second face 112 side, Fig. 4 shows a sectional view of the board 110 according to Figs. 2 and 3 along the line AA, and Fig. 5 shows a sectional view of the board 110 according to Figs. 2 and 3 along the line BB.

The first light source 120 and second light source 130 are light sources for emitting light, for example LEDs (light emitting diodes). As shown in Figs. 2 and 4, the first light source 120 is disposed on the first face 111 of the board 110. As shown in Figs. 3 to 5, the second light source 130 is disposed on the second face 112 of the board 110.

For example, the first light source 120 and the second light source 130 are intended to be used for different purposes. The first light source 120 is intended to be used e.g. for illumination. The second light source 130 is intended to be used e.g. for an indicator. For example, when the illumination device 100 is configured for illuminating a charging inlet of a vehicle, the first light source 120 is configured for illuminating the charging inlet of the vehicle, wherein the second light source 130 is intended for an indicator, the indicator being configured to indicate a state of charge of the vehicle (for example a state of charge of a battery (for example a main battery) of the vehicle).

The first wiring patterns 140 are used for electrically connecting components arranged on the first face 111 of the board 110 (including the first light source 120). As shown in Figs. 2, 4 and 5, the first wiring patterns 140 are positioned on the first face 111 of the board 110 so that the first wiring patterns 140 are brought into contact with the first face 111.

The second wiring patterns 150 are used for electrically connecting components arranged on the second face 112 of the board 110 (including the second light source 130). As shown in Figs. 3 to 5, the second wiring patterns 150 are positioned on the second face 112 of the board 110 so that the second wiring patterns 150 are brought into contact with the second face 112.

The first wiring patterns 140 and second wiring patterns 150 are made of an electrical conductor, and for example patterns of metal foils (e.g. copper foils). The first wiring patterns 140 and second wiring patterns 150 may be made of a same material or made of different materials.

The second wiring pattern 150 of the illumination device 100 according to the present embodiment is disposed so as to cover a region A12 on the second face 112, the region A12 on the second face 112 opposed to a region A11 on the first face 111 with the first light source 120 disposed therein. In this manner, a light emitted from the first light source 120 toward the board 100 is blocked by the second wiring patterns 150, as shown in Fig. 4. This means that according to the present embodiment, even when the light emitted from the first light source 120 toward the board 100 passes through the board, this light is blocked by the second wiring patterns 150. According to the present embodiment, a light coming from the first light source 120 can be prevented from arriving at the second face 112 side of the board 100, for example by providing an element for preventing the light coming from the first light source 120 from arriving at the second face 112 side of the board 100 by circumvention (for example a cover 9 as disclosed in Patent Document 1).

In the above-described manner, the present embodiment enables the light coming from the first light source 120 to be prevented from arriving at the second face 112 side of the board 100. As a result, when the second light source 130 emits no light, the present embodiment enables the second light source 130 side (the second face 112 side of the board 100) to be prevented from being illuminated. Accordingly, only when the second light source 130 is turned on, the present embodiment may allow a user to recognize the fact that the second light source 130 is turned on, wherein when the second light source 130 is not turned on, the user may not recognize that the second light source 130 is turned on.

Therefore, for example when the first light source 120 is intended to be used for illumination and the second light source 130 is intended to be used for an indicator, the present embodiment allows the user to correctly recognize indication of the indicator (indication by the second light source 130) even in the case of the light source for illumination (first light source 120) being turned on. As a result, the present embodiment enables an illumination device to be provided which includes two light sources to be used for different purposes.

Furthermore, the first wiring patterns 140 in the illumination device 100 according to the present embodiment is disposed so as to cover a region A22 on the first face 111, the region A22 on the first face 111 opposed to a region A21 on the second face 112 with the second light source 130 disposed therein. In this manner, a light emitted from the second light source 130 toward the board 100 is blocked by the first wiring patterns 140, as shown in Fig. 5. This means that according to the present embodiment, even when the light emitted from the second light source 130 toward the board 100 passes through the board, this light is blocked by the first wiring patterns 140. According to the present embodiment, a light coming from the second light source 130 can be prevented from arriving at the first face 111 side of the board 100, for example by providing an element for preventing the light coming from the second light source 130 from arriving at the first face 111 side of the board 100 by circumvention (for example the cover 9 as disclosed in Patent Document 1).

In the above-described manner, the present embodiment enables the light coming from the second light source 130 to be prevented from arriving at the first face 111 side of the board 100. As a result, when the first light source 120 emits no light, the present embodiment enables the first light source 120 side (the first face 111 side of the board 100) to be prevented from being illuminated. Accordingly, only when the first light source 120 is turned on, the present embodiment may allow the user to recognize the fact that the first light source 120 is turned on, wherein when the first light source 120 is not turned on, the user may not recognize that the first light source 120 is turned on.

The first light source 120 may be a light source for an indicator, the indicator being configured to indicate first information, wherein the second light source 130 may be a light source for an indicator, the indicator being configured to indicate second information that is different from the first information. Also in such a configuration, the present embodiment enables indications of both indicators for indicating the first information (indication via the first light source 120) and for indicating the second information (indication via the second light source 130) to be correctly recognized by the user.

### Reference Signs List

- 100: Illumination device
- 110: Board
- 111: First face of the board 110
- 112: Second face of the board 110
- 120: First light source
- 130: Second light source
- 140: First wiring patterns
- 150: Second wiring patterns
100 passes through the board, this light is blocked by the first wiring patterns 140. According to the present embodiment, a light coming from the second light source 130 can be prevented from arriving at the first face 111 side of the board 100, for example by providing an element for preventing the light coming from the second light source 130 from arriving at the first face 111 side of the board 100 by circumvention (for example the cover 9 as disclosed in Patent Document 1).

In the above-described manner, the present embodiment enables the light coming from the second light source 130 to be prevented from arriving at the first face 111 side of the board 100. As a result, when the first light source 120 emits no light, the present embodiment enables the first light source 120 side (the first face 111 side of the board 100) to be prevented from being illuminated. Accordingly, only when the first light source 120 is turned on, the present embodiment may allow the user to recognize the fact that the first light source 120 is turned on, wherein when the first light source 120 is not turned on, the user may not recognize that the first light source 120 is turned on.

The first light source 120 may be a light source for an indicator, the indicator being configured to indicate first information, wherein the second light source 130 may be a light source for an indicator, the indicator being configured to indicate second information that is different from the first information. Also in such a configuration, the present embodiment enables indications of both indicators for indicating the first information (indication via the first light source 120) and for indicating the second information (indication via the second light source 130) to be correctly recognized by the user.

### Reference Signs List

- 100: Illumination device
- 110: Board
- 111: First face of the board 110
- 112: Second face of the board 110
- 120: First light source
- 130: Second light source
- 140: First wiring patterns
- 150: Second wiring patterns

## Claims

1. An illumination device (100) comprising:
a board (110) having a first face (111) and a second face (112) opposite to the first face (111); a first light source (120) disposed on the first face (111);
a second light source (130) disposed on the second face (112); and
a second wiring pattern (150) disposed on the second face (112),
wherein the second wiring pattern (150) is disposed so as to cover a region (A12) on the second face (112), the region (A12) on the second face (112) opposed to a region (A11) on the first face (111) with the first light source (120) disposed therein,
wherein the illumination device (100) further comprises a first wiring pattern (140) disposed on the first face (111),
wherein the first wiring pattern (140) is disposed so as to cover a region (A22) on the first face (111), the region (A22) on the first face (111) opposed to a region (A21) on the second face (112) with the second light source (130) disposed therein,
**characterised in that**
the illumination device (100) is an illumination device configured for illuminating a charging inlet of a vehicle,
wherein the first light source (120) is a light source configured for illuminating the charging inlet of the vehicle, and
wherein the second light source (130) is a light source for an indicator, the indicator being configured to indicate a state of charge of the vehicle.

## Patentansprüche

1. Beleuchtungsvorrichtung (100), aufweisend:
eine Platine (110) mit einer ersten Fläche (111) und einer zweiten Fläche (112), die der ersten Fläche (111) gegenüberliegt;
eine erste Lichtquelle (120), die auf der ersten Fläche (111) angeordnet ist;
eine zweite Lichtquelle (130), die auf der zweiten Fläche (112) angeordnet ist; und
ein zweites Verdrahtungsmuster (150), das auf der zweiten Fläche (112) angeordnet ist,
wobei das zweite Verdrahtungsmuster (150) so angeordnet ist, dass es einen Bereich (A12) auf der zweiten Fläche (112) abdeckt, wobei der Bereich (A12) auf der zweiten Fläche (112) einem Bereich (A11) auf der ersten Fläche (111) gegenüberliegt, in dem die erste Lichtquelle (120) angeordnet ist,
wobei die Beleuchtungsvorrichtung (100) ferner ein erstes Verdrahtungsmuster (140) umfasst, das auf der ersten Fläche (111) angeordnet ist,
wobei das erste Verdrahtungsmuster (140) so angeordnet ist, dass es einen Bereich (A22) auf der ersten Fläche (111) abdeckt, wobei der Bereich (A22) auf der ersten Fläche (111) einem Bereich (A21) auf der zweiten Fläche (112) gegenüberliegt, in dem die zweite Lichtquelle (130) angeordnet ist,
**dadurch gekennzeichnet, dass** die Beleuchtungsvorrichtung (100) eine Beleuchtungsvorrichtung ist, die zum Beleuchten eines Ladeanschlusses eines Fahrzeugs konfiguriert ist,
wobei die erste Lichtquelle (120) eine Lichtquelle ist, die zum Beleuchten des Ladeanschlusses des Fahrzeugs konfiguriert ist, und
wobei die zweite Lichtquelle (130) eine Lichtquelle für eine Anzeigevorrichtung ist, wobei die Anzeigevorrichtung so konfiguriert ist, dass sie einen Ladezustand des Fahrzeugs anzeigt.

## Revendications

1. Dispositif d'éclairage (100) comprenant :
une carte (110) ayant une première face (111) et une seconde face (112) opposée à la première face (111) ;
une première source lumineuse (120) disposée sur la première face (111) ;
une seconde source lumineuse (130) disposée sur la seconde face (112) ; et
un second schéma de câblage (150) disposé sur la seconde face (112),
dans lequel le second schéma de câblage (150) est disposé de manière à couvrir une région (A12) sur la seconde face (112), la région (A12) sur la seconde face (112) étant opposée à une région (A11) sur la première face (111) avec la première source lumineuse (120) disposée à l'intérieur,
dans lequel le dispositif d'éclairage (100) comprend en outre un premier schéma de câblage (140) disposé sur la première face (111),
dans lequel le premier schéma de câblage (140) est disposé de manière à couvrir une région (A22) sur la première face (111), la région (A22) sur la première face (111) étant opposée à une région (A21) sur la seconde face (112) avec la seconde source lumineuse (130) disposée à l'intérieur,
**caractérisé en ce que**
le dispositif d'éclairage (100) est un dispositif d'éclairage configuré pour éclairer une entrée de charge d'un véhicule,
dans lequel la première source lumineuse (120) est une source lumineuse configurée pour éclairer l'entrée de charge du véhicule, et
dans lequel la seconde source lumineuse (130) est une source lumineuse pour un indicateur, l'indicateur étant configuré pour indiquer un état de charge du véhicule.
